# EUROPEAN PATENT APPLICATION

(11) **EP 1 321 976 A2**
(43) Date of publication of application: **25.06.2003**
(21) Application number: 02024920.7
(22) Date of filing: 06.11.2002
(51) Int. Cl.: H01L 21/316, C23C 16/40, H01L 21/768

(54) **Method of depositing a barrier insulating layer with low dielectric constant on a copper film**

(30) Priority: 06.12.2001 JP 2001372299; 26.04.2002 JP 2002127388
(71) Applicant: Canon Sales Co., Inc., Minato-ku, Tokyo 108-0073 (JP); Semiconductor Process Laboratory Co., Ltd., Minato-ku, Tokyo 108-0075 (JP)
(72) Inventor: Shioya, Yoshimi, Semiconductor Pro. Lab. Co., Ltd., Minato-ku, Tokyo 108-0075 (JP); Nishimoto, Yuhko, Semiconductor Pro.Lab. Co., Ltd., Minato-ku, Tokyo 108-0075 (JP); Suzuki, Tomomi, Canon Sales Co., Ltd., Minato-ku, Tokyo 108-0075 (JP); Maeda, Kazuo, Semiconductor Pro.Lab. Co., Ltd., Minato-ku, Tokyo 108-0075 (JP)
(74) Representative: Marx, Lothar, Dr.

(57) **Abstract**

Disclosed is a method of manufacturing a semiconductor device in which a barrier insulating film covering a copper wiring is formed by a plasma enhanced CVD method. The method comprises the steps of connecting a supply power source for supplying high frequency power of a frequency of 1 MHz or more to a first electrode 2, and holding a substrate 21 on a second electrode 3 facing the first electrode 2, the substrate 21 on which a copper wiring is formed; supplying a film forming gas containing an alkyl compound and an oxygen-containing gas between the first and second electrodes 2, 3, and regulating a gas pressure of the film forming gas to 1 Torr or less; and supplying the high frequency power to any one of the first and second electrodes 2, 3 to convert the film forming gas into a plasma state, and allowing the alkyl compound and the oxygen-containing gas of the film forming gas to react with each other and thus form a barrier insulating film covering the surface of the substrate 21.

## Description

### BACKGROUND OF THE INVENTION

### 1. Field of the Invention

The present invention relates to a method of manufacturing a semiconductor device, and more particularly to a method of manufacturing a semiconductor device in which a barrier insulating film for covering a copper wiring is formed by use of a plasma enhanced CVD method.

### 2. Description of the Prior Art

Recent years, a high speed of a data transfer speed has been desired along with a high integration and high density of a semiconductor integrated circuit device. Therefore, an insulating film having a low dielectric constant with a less RC delay (hereinafter referred to as a low dielectric constant insulating film) has been used.

On the other hand, with respect to a wiring material, a copper (Cu) wiring showing a low electric resistivity has come to be used instead of the conventional aluminum (A1) wiring.

Therefore, as an interlayer insulating film, the low dielectric constant insulating film is formed on the copper wiring. When the low dielectric constant insulating film is formed after the formation of the copper wiring, or alternatively in steps after the formation of the copper wiring, annealing at about 400 to about 450 °C is carried out. Moreover, a high field is applied to the interlayer insulating film during the operation of the semiconductor device. Accordingly, to prevent diffusion of copper into the low dielectric insulating film owing to heat and electric field, a barrier insulating film is sandwiched between the low dielectric constant insulating film and the copper wiring.

However, the barrier insulating film is dense but shows a high relative dielectric constant. Among various barrier insulating films, a SiC-based barrier insulating film shows a relative dielectric constant as relatively low as about 5. However, when a thickness of a barrier insulating film having a relative dielectric constant of 5 is made to be 100 nm relative to a low dielectric constant insulating film having a thickness of 500 nm and a relative dielectric constant of 2.8, a relative dielectric constant of an interlayer insulating film composed of the low relative dielectric constant insulating film and the barrier insulating film becomes as high as 3.02.

Therefore, it has been tried to make the thickness of the barrier insulating film as thin as about 50 nm. However, in this case, a capability to prevent copper diffusion is deteriorated.

### SUMMARY OF THE INVENTION

The present invention relates to a semiconductor device having a barrier insulating film with a low relative dielectric constant, which covers a wiring formed of a copper film or mainly formed of a copper film, and relates to a method of manufacturing the same. An object of the present invention is to provide a semiconductor device having a barrier insulating film with a low relative dielectric constant, which shows a small leak current and high capability to prevent copper diffusion, and to provide a method of manufacturing the same.

In the present invention, a film forming gas containing an alkyl compound and an oxygen-containing gas is supplied between first and second electrodes, and gas pressure is regulated to 1 Torr or less. Thereafter, high frequency power of a frequency of 1 MHz or more is applied to any one of the first and second electrodes, and the film forming gas is converted into a plasma. The plasmanized film forming gas are reacted with each other, and a barrier insulating film covering a copper wiring is formed.

The use of the film forming gas converted into a plasma state only by the high frequency power makes it possible to acquire a low relative dielectric constant. Moreover, it is possible to maintain denseness of the insulating film enough to prevent copper diffusion by controlling the pressure of the film forming gas to 1 Torr or less at least at an early stage of the film formation.

To increase the denseness of the insulating film while maintaining the low relative dielectric constant thereof, the film formation is carried out under a condition that the pressure of the film forming gas is gradually elevated from low pressure to 1 Torr in the present invention. Alternatively, ammonium (NH₃) and nitrogen (N₂) are added to the film forming gas at least at the early stage of the film formation. Alternatively, a film forming gas containing a dilution gas formed of at least any one of He and Ar is used. Alternatively, the film forming gas is used under a condition that a flow rate of the dilution gas is increased at least at the early stage of the film formation. Alternatively, bias power of a low frequency is applied at the early stage of the film formation.

Moreover, hydrocarbon is added to the film forming gas. Thus, the formed film can be enhanced in etching selectivity for the etchant of the insulating film with the low relative dielectric constant, which is formed on the barrier insulating film.

As described above, according to the present invention, the barrier insulating film having a further low relative dielectric constant can be formed while maintaining the denseness enough to prevent the copper diffusion.

### BRIEF DESCRIPTION OF THE DRAWINGS

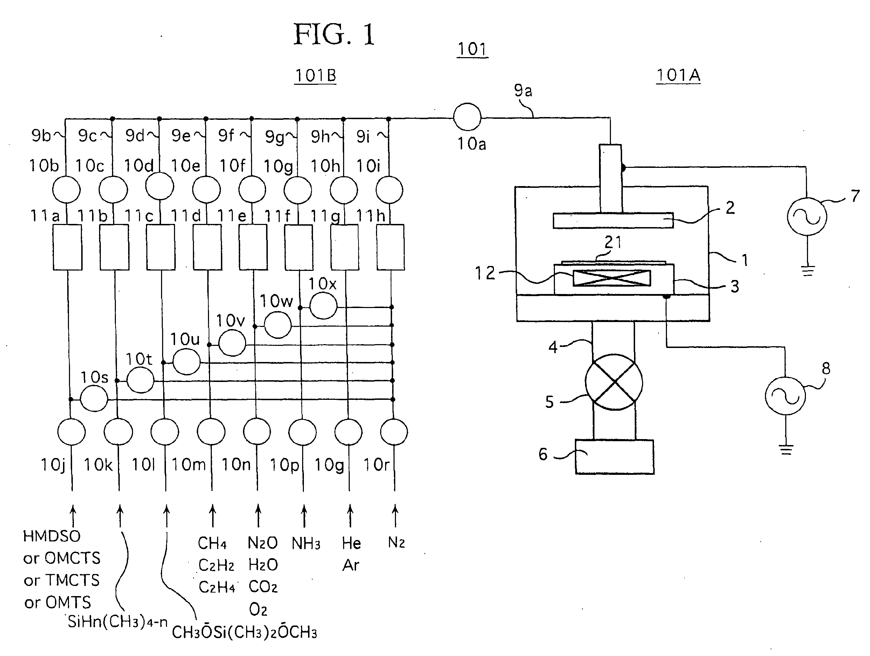

FIG. 1 is a side view illustrating a constitution of a plasma enhanced CVD apparatus used for a method of manufacturing a semiconductor device, which is an embodiment of the present invention.

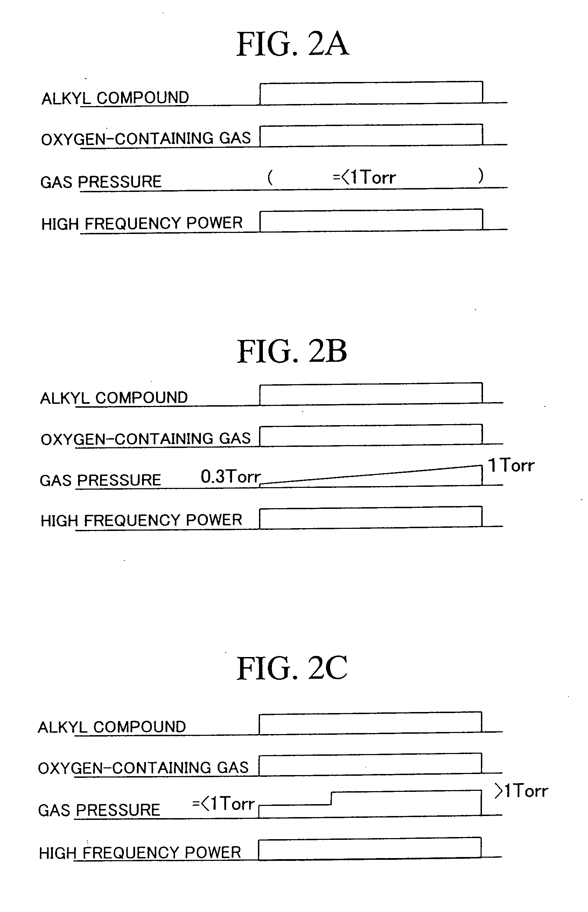

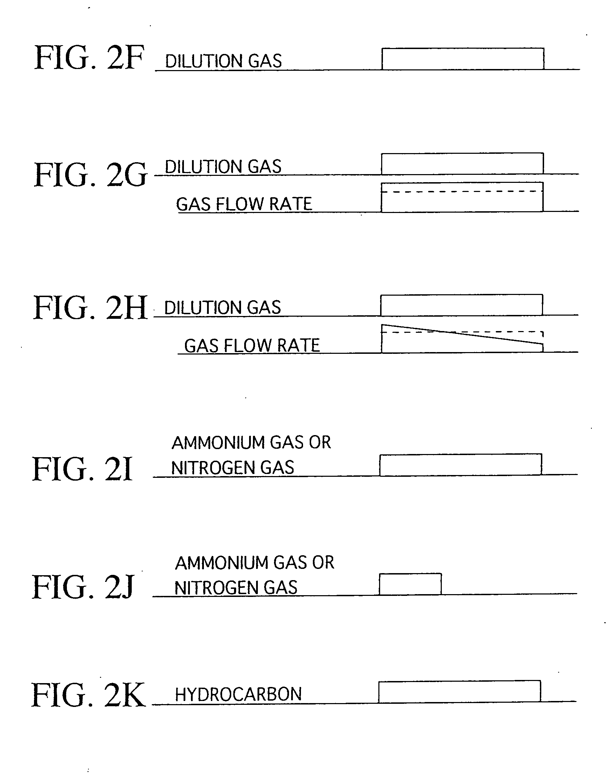

FIGs. 2A to 2K are charts illustrating a film forming method using particularly effective combinations of gases and effective combinations of film forming conditions, which are the embodiment of the present invention.

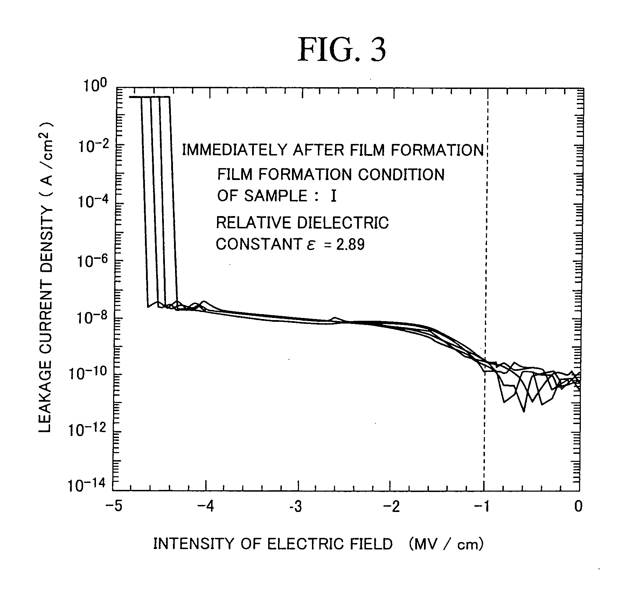

FIG. 3 is a graph illustrating a characteristic of a leakage current of a silicon-containing insulating film immediately after a film formation (as depo.), which is formed under a film forming condition I by a film forming method of a first embodiment of the present invention.

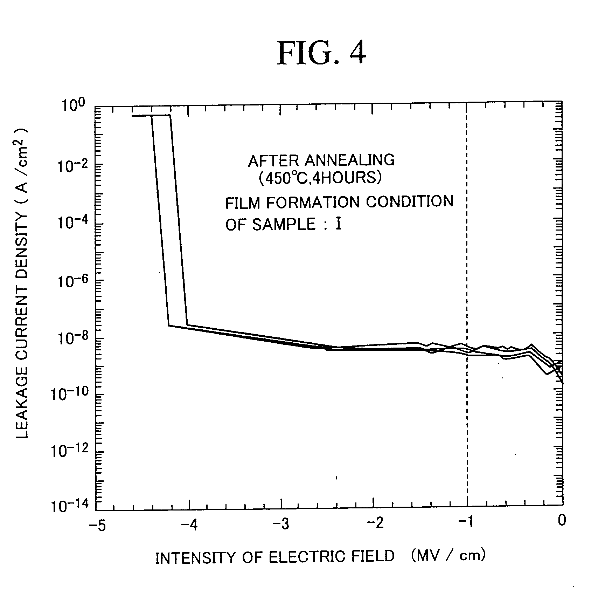

FIG. 4 is a graph illustrating a characteristic of the leakage current of the silicon-containing insulating film immediately after the film formation (as depo.) and after annealing, which is formed under the film forming condition I by the film forming method of the first embodiment of the present invention.

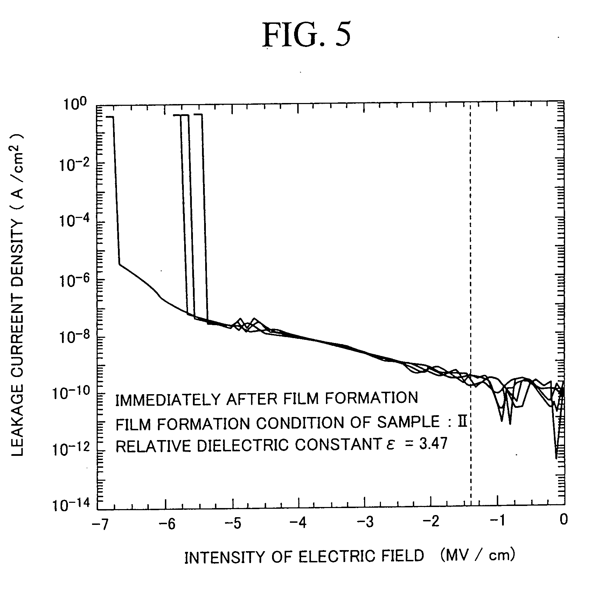

FIG. 5 is a graph illustrating a characteristic of a leakage current of a silicon-containing insulating film immediately after a film formation (as depo.), which is formed under a film forming condition II by a film forming method of a second embodiment of the present invention.

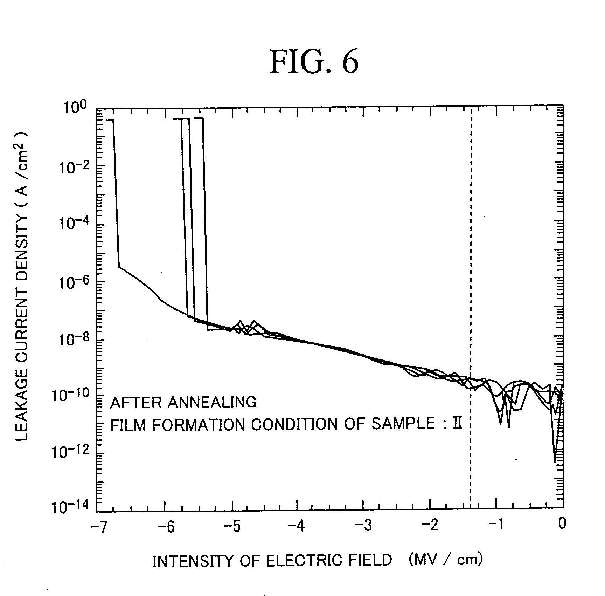

FIG. 6 is a graph illustrating a characteristic of the leakage current of the silicon-containing insulating film immediately after the film formation (as depo.) and after annealing, which is formed under the film forming condition II by the film forming method of the second embodiment of the present invention.

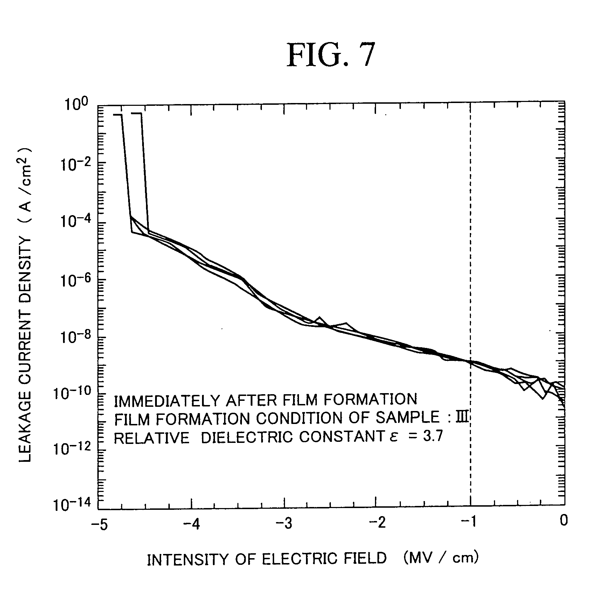

FIG. 7 is a graph illustrating a characteristic of a leakage current of a silicon-containing insulating film immediately after a film formation (as depo.), which is formed under a film forming condition III by a film forming method of a third embodiment of the present invention.

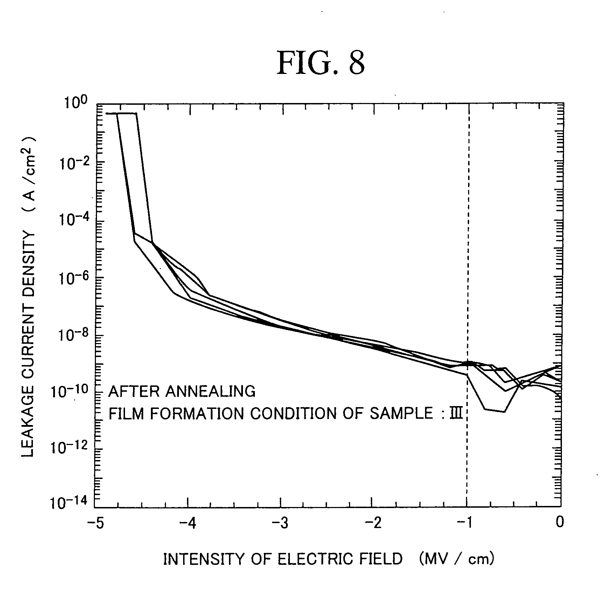

FIG. 8 is a graph illustrating a characteristic of the leakage current of the silicon-containing insulating film immediately after the film formation (as depo.) and after annealing, which is formed under the film forming condition III by the film forming method of the third embodiment of the present invention.

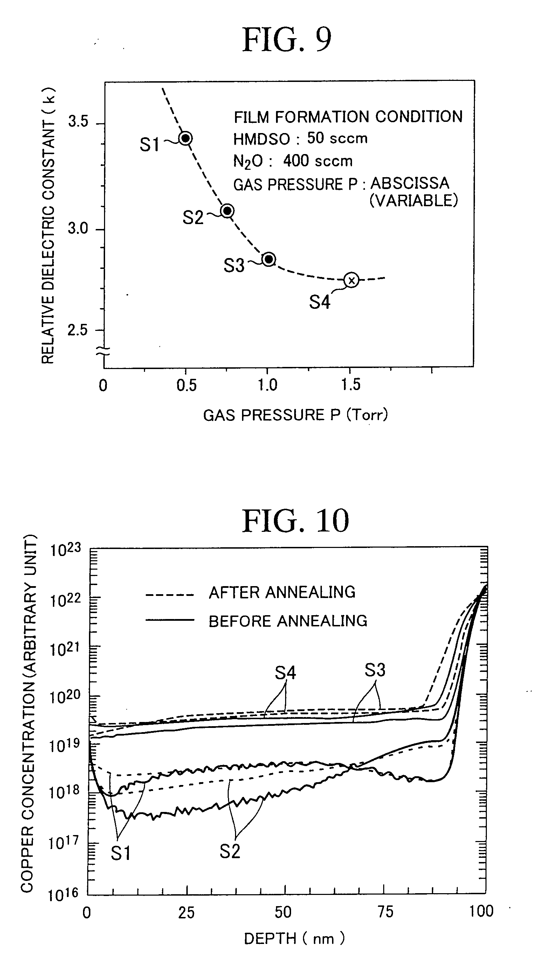

FIG. 9 is a graph illustrating states of a change of a relative dielectric constant (k) of an insulating film relative to a gas pressure (P) of a film forming gas, and a relationship of a dielectric breakdown-resistance of the insulating film after annealing with the gas pressure (P) and the relative dielectric constant (k), for the insulating film which is prepared under a film forming condition IV by a film forming method of a fourth embodiment of the present invention.
FIG. 10 is a graph illustrating a barrier property for copper in the insulating film prepared under the condition IV by the film forming method of the fourth embodiment of the present invention.

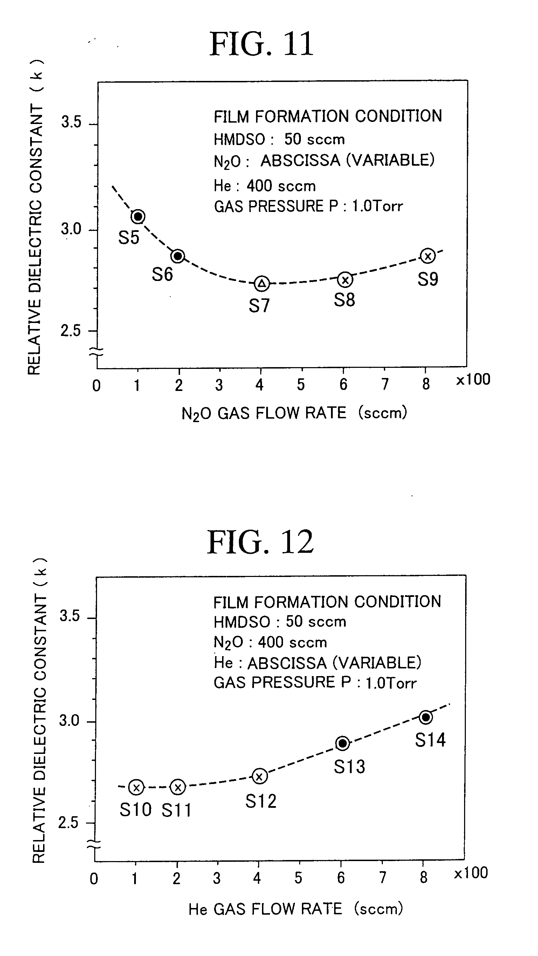

FIG. 11 is a graph illustrating states of a change of a relative dielectric constant (k) of an insulating film relative to a N₂O gas flow rate in a film forming gas, and a relationship of a dielectric breakdown-resistance of the insulating film after annealing with the N₂O gas flow rate and the relative dielectric constant (k), for the insulating film which is prepared under a film forming condition V by a film forming method of a fifth embodiment of the present invention.
FIG 12 is a graph illustrating states of a change of a relative dielectric constant (k) of an insulating film relative to a He gas flow rate in a film forming gas, and a relationship of a dielectric breakdown-resistance of the insulating film after annealing with the He gas flow rate and the relative dielectric constant (k), for the insulating film which is prepared under a film forming condition VI by a film forming method of a sixth embodiment of the present invention.

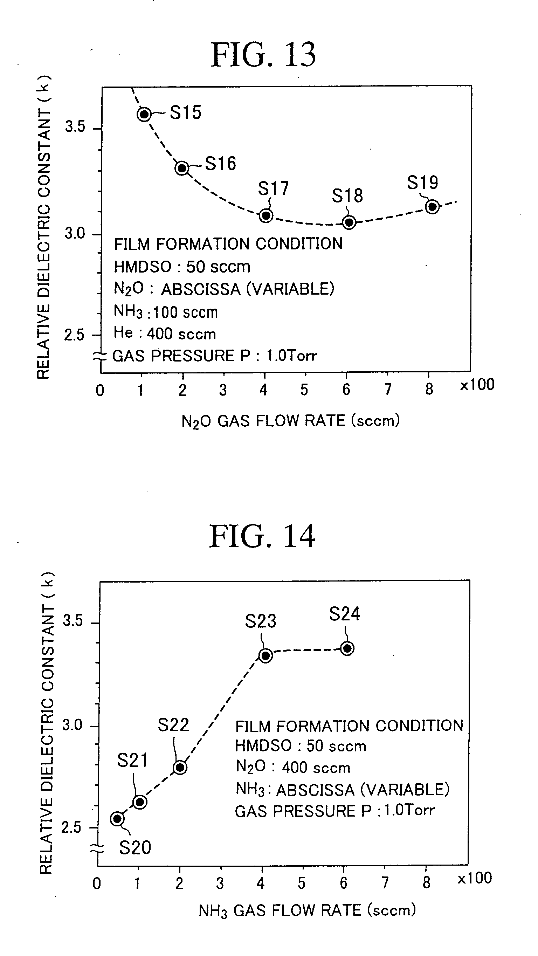

FIG. 13 is a graph illustrating states of a change of a relative dielectric constant (k) of an insulating film relative to a N₂O gas flow rate in a film forming gas, and a relationship of a dielectric breakdown-resistance of the insulating film after annealing with the N₂O gas flow rate and the relative dielectric constant (k), for the insulating film which is prepared under a film forming condition VII by a film forming method of a seventh embodiment of the present invention.
FIG. 14 is a graph illustrating states of a change of a relative dielectric constant (k) of an insulating film relative to a NH₃ gas flow rate in a film forming gas, and a relationship of a dielectric breakdown-resistance of the insulating film after annealing with the NH₃ gas flow rate and the relative dielectric constant (k), for the insulating film which is prepared under a film forming condition VIII by a film forming method of an eighth embodiment of the present invention.

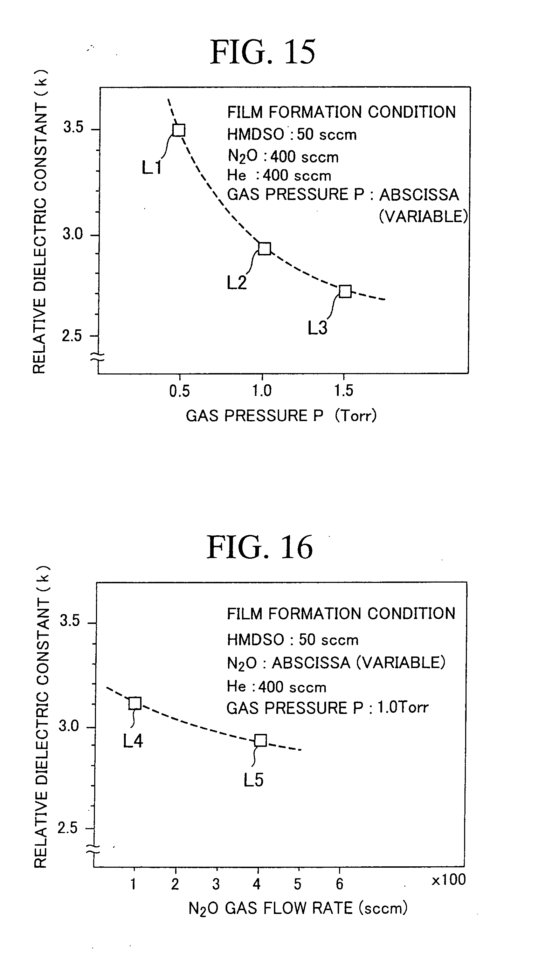

FIG. 15 is a graph illustrating states of a change of a relative dielectric constant (k) of an underlying film of two insulating films relative to sorts of the underlying film and gas pressure (P) of a film forming gas, for the underlying film which are prepared under a film forming condition IX by a film forming method of a ninth embodiment of the present invention.
FIG. 16 is a graph illustrating states of a change of a relative dielectric constant (k) of an underlying film of two insulating films relative to sorts of the underlying film and a N₂O gas flow rate of a film forming gas, for the underlying film which are prepared under a film forming condition X by the film-forming method of the ninth embodiment of the present invention.

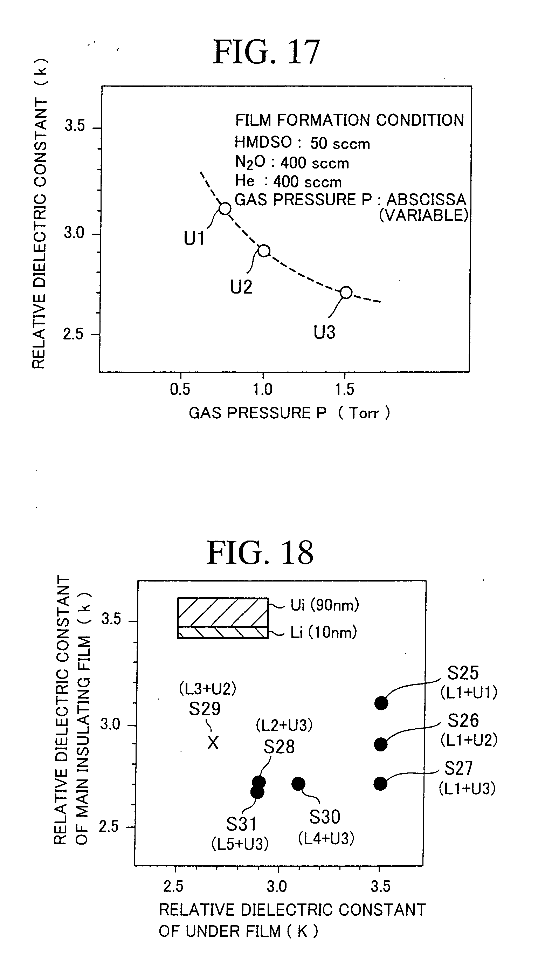

FIG. 17 is a graph illustrating states of a change of a relative dielectric constant (k) of a main insulating film of two insulating films relative to sorts of the main insulating film and gas pressure of a film forming gas, for the main film which are prepared under a film forming condition XI by the film forming method of the ninth embodiment of the present invention.
FIG. 18 is a graph illustrating a relationship of a dielectric breakdown-resistance with relative dielectric constants (k) of a underlying film and a main insulating film concerning a two-layered insulating film which is a combination of the underlying film and the main insulating film prepared under the film forming conditions IX, X and XI by the film forming method of the ninth embodiment of the present invention.

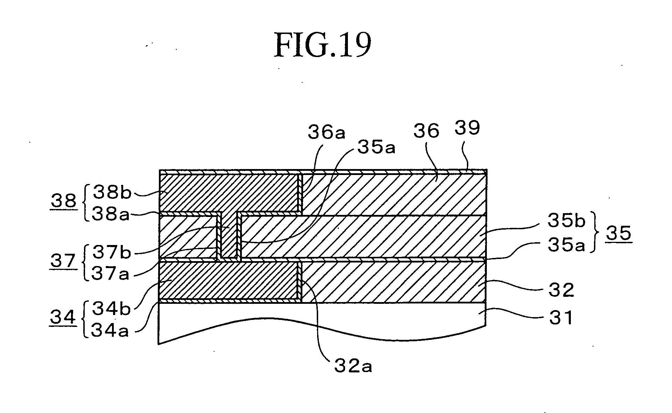

FIG.19 is a sectional view of a semiconductor device in which the present invention is applied to a barrier insulating film covering a wiring made mainly of copper.

### DESCRIPTION OF THE PREFERRED EMBODIMENTS

Embodiments of the present invention will be described with reference to the accompanying drawings below.

### (Description of a plasma enhanced CVD apparatus used for a film forming method which is an embodiment of the present invention)

FIG. 1 is a side view illustrating a constitution of a parallel plate plasma enhanced CVD apparatus 101 used for a method of manufacturing a semiconductor device according to an embodiment of the present invention.

This parallel plate plasma enhanced CVD apparatus 101 is constituted by a film forming portion 101A where a barrier insulating film is formed on a substrate 21 subject to film formation by use of a plasma gas, and a film forming gas supply portion 101B having a plurality of gas supply sources constituting a film forming gas.

The film forming portion 101A comprises a chamber 1 in which pressure can be reduced, as shown in FIG. 1, and the chamber 1 is connected to an exhaustion device 6 through an exhaustion pipe 4. An open/close valve 5 for controlling communication/noncommunication between the chamber 1 and the exhaustion device 6 is provided in the exhaustion pipe 4. Pressure measurement means such as a vacuum gauge (not shown) for monitoring pressure in the chamber 1 is provided in the chamber 1.

A pair of upper and lower electrodes (first and second electrodes) 2 and 3, which oppose to each other, are provided in the chamber 1. A high frequency electric power supply source (RF electric power supply source) 7 for supplying high frequency electric power of a frequency of 13.56 MHz is connected to the upper electrode 2. A low frequency electric power supply source 8 for supplying low frequency electric power of a frequency of 380 kHz is connected to the lower electrode 3. The high frequency electric power is supplied to the upper electrode 2 from at least the high frequency electric power supply source 7 of these power sources 7 and 8, and the film forming gas is converted to a plasma. The upper electrode 2, the lower electrode 3 and the power sources 7 and 8 constitute plasma generation means for converting the film forming gas into a plasma.

Note that not only the low frequency electric power of the frequency of 380 kHz but also low frequency electric power of a frequency ranging from 50 kHz to 1 MHz can be applied to the lower electrode 3. Moreover, not only the high frequency electric power of the frequency of 13.56 MHz but also high frequency electric power of a frequency of 1 MHz or more can be applied to the upper electrode 2 facing the lower electrode 3. In FIG. 1, a high frequency power source is connected to the upper electrode 2, and a low frequency electric power source is connected to the lower electrode 3. However, the object of the present invention can be achieved as long as the high frequency electric power source 7 is connected to the lower electrode 3 or to any one of the upper and lower electrodes 2 and 3, and the lower frequency electric power source 8 is connected to the lower electrode 3 or to the other electrode.

The upper electrode 2 serves also as a dispersion head of the film forming gas. A plurality of through holes for guiding the film forming gas are formed in the upper electrode 2. Each through hole is communicated to an opening portion in the facing plane of the lower electrode 3 and the opening portion serves as a discharging port (introduction port) of the film forming gas. The discharging port for this film forming gas is connected to the film forming gas supply portion 101B by a pipe 9a. A heater (not shown) may be provided in some cases in the upper electrode 2. The heater is provided so that particles formed of reaction product of the film forming gas are prevented from being adhered to the upper electrode 2 by heating the upper electrode 2 to about 100 °C during the film formation.

The lower electrode 3 serves also as a holding stage of the substrate 21. Moreover, the lower electrode 3 comprises a heater 12 for heating the substrate 21 on the holding stage.

In the film forming gas supply portion 101B, there are provided a supply source for supplying an alkyl compound having a siloxane bond such as hexamethyl disiloxane (HMDSO: (CH₃)₃Si-O-Si(CH₃)₃) or the like, a supply source for supplying methyl silane expressed by a general formula: SiHn(CH₃)₄₋ₙ (n = 0 to 3), a supply source for supplying an alkyl compound having an O-Si-O bond, a supply source for supplying hydrocarbon (CₘHₙ) such as methane (CH₄), acetylene (C₂H₂) and ethylene (C₂H₄), a supply source for supplying an oxygen-containing gas such as oxygen (O₂), dinitrogen monoxide (N₂O), water (H₂O), carbon dioxide (CO₂), a supply source for supplying ammonium (NH₃), a supply source for supplying an dilution gas formed of at least any one of He and Ar (inert gas), and a supply source for supplying nitrogen (N₂) that is also an inert gas.

These gases are suitably supplied to the chamber 1 in the film forming portion 101A through branch pipes 9b to 9i and the pipe 9a connected to the branch pipes 9b to 9i. In the respective branch pipes 9b to 9i, there are provided flow rate adjusting means 11a to 11h and open/close means 10b to 10n and 10p to 10r for controlling communication/noncommunication of the branch pipes 9b to 9i. Open/close means 10a for opening/closing the pipe 9a is provided in the pipe 9a. Moreover, close/open means 10s to 10x for controlling communication/noncommunication between the branch pipe 9i connected to the supply source of a N₂ gas and the other branch pipes 9b and 9g are provided in order to purge a residual gas in the branch pipes 9b to 9g by allowing the N₂ gas to flow therethrough. Note that the N₂ gas is used also for purging a residual gas in the pipe 9a and the chamber 1 as well as in the branch pipes 9b to 9g. Moreover, the N₂ gas is in some cases used as the film forming gas.

According to the film formation apparatus 101 as described above, there are provided the supply source for supplying the alkyl compound having the siloxane bond such as hexamethyl disiloxane (HMDSO), the supply source for supplying methyl silane expressed by general formula: SiHn(CH₃)₄₋ₙ (n = 0 to 3), the supply source for supplying the alkyl compound having the O-Si-O bond, the supply source for supplying hydrocarbon (CₘHₙ), the supply source for supplying the oxygen-containing gas such as oxygen (O₂), dinitrogen monoxide (N₂O), water (H₂O), carbon dioxide (CO₂), the supply source for supplying ammonium (NH₃), the supply source for supplying the dilution gas formed of at least any one of He and Ar (inert gas), and the supply source for supplying nitrogen (N₂) that is also an inert gas. Moreover, plasma generating means 2, 3, 7 and 8 for converting the film forming gas into a plasma are provided.

Thus, it is possible to form a barrier insulating film with a low dielectric constant and high denseness, which is capable of suppressing copper diffusion, by use of a plasma enhanced CVD method described below.

FIG.19 is a sectional view of a semiconductor device in which the above film forming method is applied to a barrier insulating film covering a wiring made mainly of copper. In FIG.19, films denoted by symbols 35a, 39 are the barrier insulating films covering a lower wiring and upper wiring made mainly of copper, respectively.

In the semiconductor device, there are laminated a lower wiring berried insulating film 32, an inter wiring layer insulating film 35 and an upper wiring berried insulating film 36 on the substrate 31. The wiring berried insulating film 32, 36 both are formed of a low dielectric insulating film, and the inter wiring layer insulating film 35 is formed of a two-layered structure of the barrier insulating film and a low dielectric insulating film.

The lower wiring 34 is berried in a wiring trench 32a of the wiring berried insulating film 32, and the upper wiring 38 is berried in a wiring trench 36a of the wiring berried insulating film 36. The lower wiring 34 and the upper wiring 38 are connected with each other by a connection conductor 37 berried in a via hole 35a formed through the inter wiring layer insulating film 35. The lower wiring 34, the connection conductor 37 and the upper wiring 38 are formed of main copper films 34b, 37b, 38b, and barrier metal films 34a, 37a, 38a which protect lower parts and side portions of main copper films 34b, 37b, 38b. The barrier insulating films 35a, 39 cover the upper surfaces of the copper films 34b, 38b, respectively.

Next, there will be made descriptions for an alkyl compound having a siloxane bond, methyl silane, an alkyl compound having an O-Si-O bond, and hydrocarbon, which are the film forming gas of the barrier insulating film used for the present invention.

The following can be used as the representative example.
(i) alkyl compound having a siloxane bond
   hexamethyldisiloxane (HMDSO: (CH₃)₃Si-O-Si(CH₃)3)
   octamethylcyclotetrasiloxane (OMCTS) 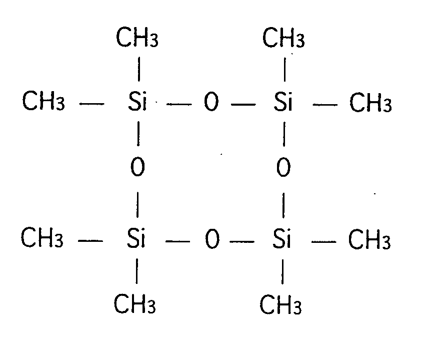
   tetramethylcyclotetrasiloxane (TMCTS) 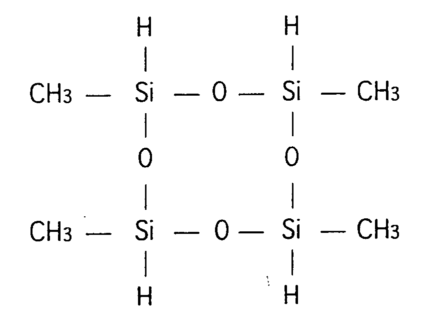
   octamethyltrisiloxane (OMTS) 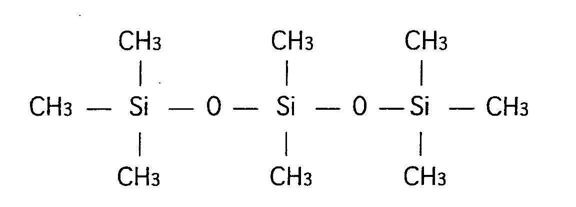
(ii) methyl silane (SiHₙ(CH₃)₄₋ₙ: n = 0 to 3)
   monomethylsilane (SiH₃(CH₃))
   dimethylsilane (SiH₂(CH₃)₂)
   trimethylsilane (SiH(CH₃)₃)
   tetramethylsilane (Si(CH₃)₄)
(iii) alkyl compound having an O-Si-O bond
   compound having a structural formula of CH₃-O-Si(CH₃)₂-O-CH₃
(iv) hydrocarbon (CₘHₙ)
   methane (CH₄)
   acetylene (C₂H₂)
   ethylene (C₂H₄)

### (Description of a film forming method of an embodiment of the present invention)

Next, a film forming method using a particularly effective combination of gases and an effective combination of film forming conditions, which is the embodiment of the present invention, will be described with reference to FIGs. 2A to 2K.

These drawings are charts illustrating a timing of an introductions of each gas composing the film forming gas into the chamber 1, conditions of a gas flow rate and gas pressure during the film formation, and a method of applying high frequency power and low frequency power applied to two electrodes of parallel plate type during the film formation.

Among these drawings, FIGs. 2A to 2E illustrates the charts of the method of forming a silicon-containing insulating film by use of a film forming gas composed of at least an alkyl compound and an oxygen-containing gas.

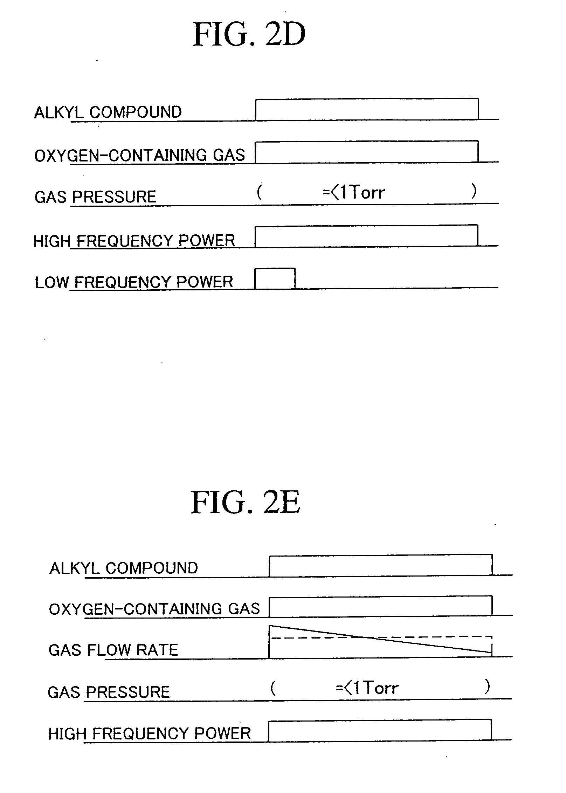

In FIG. 2A, the pressure of the film forming gas introduced into the chamber 1 is regulated to 1 Torr or less, and high frequency power is applied to any one of the lower and upper electrodes 2 and 3, thus converting the film forming gas into a plasma state. The chart of FIG. 2B differs from that of FIG. 2A in that the film formation is carried out while increasing the pressure of the film forming gas from low pressure to 1 Torr gradually. The chart of FIG. 2C differs from that of FIG. 2A in that the pressure of the film forming gas introduced into the chamber 1 is regulated to 1 Torr or less for a certain period of time at the early stage of the film formation, and then regulated to a higher pressure than 1 Torr after passage of the certain period of time. The chart of FIG. 2D differs from that of FIG. 2A in that high frequency power is applied to any one of the upper and lower electrodes 2 and 3 and low frequency power is applied to the other electrode for a certain period of time at the early stage of the film formation. The chart of FIG. 2E differs from that of FIG. 2A in that the flow rate of the oxygen-containing gas of the film forming gas is made to be high for a certain period of time at the early stage of the film formation and is made to be low after passage of the certain period of time.

Moreover, in FIGs. 2F to 2K described below, on the assumption that the gases shown in the drawings are composed by adding these gases to other gases, only conditions under which each of the gases is added to other gases are illustrated.

FIGs. 2F to 2H are charts when the film formation is carried out by use of a film forming gas containing dilution gas.

In FIG. 2F, the dilution gas of an ordinary flow rate is added. The chart of FIG. 2G differs from that of FIG. 2F in that the flow rate of the dilution gas is increased. The chart of FIG. 2H differs from that of FIG. 2F in that the flow rate of the dilution gas is increased for a certain period of time at the early stage of the film formation and, then, is lowered after passage of the certain period of time.

FIGs. 2I to 2J are charts when the film formation is carried out by use of a film forming gas containing at least any one of an ammonium gas and a nitrogen gas.

In the chart of FIG. 2I, at least any one of the ammonium gas and the nitrogen gas is added through the entire period of the film formation. The chart of FIG. 2J differs from that of FIG. 2I in that at least any one of the ammonium gas and the nitrogen gas is supplied only for a certain period of time at the early stage of the film formation.

The combinations of the gases illustrated in FIGS. 2F to 2K and other gases are realized by the following methods (a) to (c). (a) The gas of FIGs. 2B, 2D or 2E and any one of gases of FIGs. 2F to 2K can be combined. (b) The gas obtained by combining the gas of FIGs. 2B, 2D or 2E with any one of the gases of FIGs. 2F to 2H can be combined with any one of gases of FIGs. 2I to 2J. Moreover, (c) each gas obtained as a result of the combinations of (b) can be combined with the gas of FIG. 2K.

By use of the film forming gas which is converted into a plasma state only by the high frequency power, a low relative dielectric constant can be achieved. Furthermore, it is possible to maintain denseness of the insulating film enough to prevent copper diffusion by controlling the pressure of the film forming gas to 1 Torr or less at least at the early stage of the film formation.

By forming the film while gradually increasing the pressure of the film forming gas from low pressure to 1 Torr, a dense film can be obtained at the portion closer to the wiring or the electrode mainly formed of the copper film, and a film with a lower dielectric constant can be obtained as the film is apart from the wiring or the electrode.

Moreover, the denseness can be enhanced by adding ammonium (NH₃) or nitrogen (N₂) to the film forming gas at least at the early stage of the film formation, or by using the film forming gas containing the dilution gas composed of He, or by using the film forming gas increasing the flow rate of the dilution gas at least at the early stage of the film formation, or by applying bias power of the low frequency at the early stage of the film formation.

Moreover, by adding the hydrocarbon, it is possible to enhance an etching resistance to an etchant of the low dielectric constant film formed on the barrier insulating film.

As described above, the film formation is carried out by use of a plasma enhanced CVD method to which the present invention is applied according to the foregoing chart, whereby it is possible to form the barrier insulating film which is dense enough to prevent the copper diffusion and has a low relative dielectric constant.

Next, there will be described results of examinations of the relative dielectric constant and leakage current of the silicon-containing insulating film, which is formed under various film forming conditions by the method of manufacturing a semiconductor device to which the present invention is applied by use of the foregoing plasma enhanced CVD apparatus.
(1) First embodiment
   As a sample, after a surface oxide film on a copper film was removed by a treatment prior to a film formation, a silicon-containing insulating film was formed on the copper film. The silicon-containing insulating film was formed under the following film forming conditions by use of a plasma enhanced CVD method.

### (Treatment prior to film formation)

(i) treatment gas: NH₃
   gas flow rate: 500 sccm
   gas pressure: 1 Torr
(ii) condition for plasma formation
   frequency: 13.56 MHz
   power: 100 W
   time: 10 seconds
(iii) substrate heating temperature: 375 °C

### (Film forming condition I)

(i) condition of film forming gas
   HMDSO flow rate: 50 sccm
   N₂O flow rate: 400 sccm
   He flow rate: 400 sccm
   gas pressure: 1 Torr
(ii) condition for plasma formation
   high frequency power (13.56 MHz) PRF: 250 W
   low frequency power (380 KHz) PLF: 0 W
(iii) substrate heating temperature: 375 °C
(iv) formed silicon-containing insulating film
   film thickness: 100 nm
   relative dielectric constant: 2.89

### (Annealing condition)

temperature: 450 °C
treatment time: 4 hours

In the measurement of the relative dielectric constant, a mercury probe having an electrode area of 0.0226 cm² was allowed to touch the surface of the silicon-containing insulating film. Then, a DC bias voltage was applied to the mercury probe along with a small signal voltage of 1 MHz. The relative dielectric constant was obtained by performing a conversion from the measured C-V characteristics.

Moreover, in the measurement of the leakage current and the dielectric breakdown-resistance, the copper film was grounded and a negative voltage was applied to the mercury probe.

The results obtained by measuring the leakage current and the dielectric breakdown-resistance are shown in FIG. 3 and FIG. 4. FIG. 3 and FIG. 4 are graphs obtained by examining the leakage current and the dielectric breakdown-resistance, the leakage current flowing between the mercury probe and the copper film which sandwich the silicon-containing insulating film therebetween. FIG. 3 shows the results obtained by examination immediately after forming the silicon-containing insulating film. FIG. 4 shows the results obtained by examination after forming the silicon-containing insulating film and after annealing the silicon-containing insulating film under the foregoing conditions.

The ordinate of FIG. 3 indicates a leakage current density (A/cm²) expressed by a logarithmic scale, and the abscissa of FIG. 3 indicates an intensity (MV/cm) of electric field expressed by a linear scale, the electric field being applied to the silicon-containing insulating film. Note that the negative sign of the abscissa expresses that a negative potential is applied to the silicon-containing insulating film. FIG. 4 shows the same aspect as FIG. 3.

As shown in FIG. 3 and FIG. 4, the leakage current is nearly equal to 10⁻¹⁰ A/cm² when the intensity of the electric field is -1 MV/cm. All over the measurement ranges of the electric field intensity, the leakage current hardly changes before and after the performance of annealing.

The fact that the leakage current rapidly rises up between -4 MV/cm and -5 MV/cm in FIGs. 3 and 4 implies the occurrence of the dielectric breakdown in the silicon-containing insulating film due to the electric field. The electric filed at which the dielectric breakdown occurs decreases a little after annealing. The electric field intensity at which the dielectric breakdown occurs is equal to -4 MV/cm or more, and this electric filed intensity is close to the substantial dielectric breakdown-resistance of the insulating film itself. This result shows that the copper diffusion is suppressed.

In the foregoing descriptions, though HMDSO having the siloxane bond is used as the alkyl compound, foregoing other alkyl compounds having the siloxane bond, for example, octamethylcyclotetrasiloxane (OMCTS), tetramethylcyclotetrasiloxane (TMCTS) or octamethyl-trisiloxane (OMTS) can be used. Further, methylsilane (SiHₙ(CH₃)₄₋ₙ: n=0 to 3) or an alkyl compound having an O-Si-O bond can be used.
(2) Second embodiment
   As a sample, after a surface oxide film on a copper film was removed by a treatment prior to a film formation similarly to the first embodiment, a silicon-containing insulating film was formed on the copper film. The silicon-containing insulating film was formed under the following film forming conditions by use of a plasma enhanced CVD method.
   As the sample, the silicon-containing insulating film was formed under the following film forming conditions by use of the plasma enhanced CVD method. Note that treatment conditions prior to the film formation and annealing conditions are the same as those of the first embodiment.

### (Film forming condition II)

(i) condition of film forming gas
   HMDSO flow rate: 50 sccm
   N₂O flow rate: 400 sccm
   He flow rate: 400 sccm
   gas pressure: 0.5 Torr
(ii) condition for plasma formation
   high frequency power (13.56 MHz) PRF: 250 W
   low frequency power (380 KHz) PLF: 0 W
(iii) substrate heating temperature: 375 °C
(iv) formed silicon-containing insulating film
   film thickness: 100 nm
   relative dielectric constant: 3.47

   Measurements of the relative dielectric constant and the leakage current were conducted in the same manner as the first embodiment.
   According to the measurement result, the relative dielectric constant was 3.47 as described above.
   Next, the results obtained by measuring the leakage current are shown in FIG. 5 and FIG. 6. FIG. 5 and FIG. 6 are graphs obtained by examining the leakage current flowing between the mercury probe and the copper film as to the foregoing sample, which sandwich the silicon-containing insulating film therebetween. FIG. 5 illustrates the results obtained by examination immediately after forming the silicon-containing insulating film. FIG. 6 illustrates the results obtained by examination after forming the silicon-containing insulating film and after annealing the silicon-containing insulating film.
   The ordinate of FIG. 5 indicates a leakage current density (A/cm²) expressed by a logarithmic scale, and the abscissa of FIG. 5 indicates an intensity (MV/cm) of electric field expressed by a linear scale, the electric field being applied to the silicon-containing insulating film. FIG. 6 illustrates the same aspect as FIG. 5.
   As illustrated in FIG. 5 and FIG. 6, the leakage current is equal to 10⁻⁹ A/cm² or less when the intensity of the electric field is -1 MV/cm immediately after the film formation. All over the measurement ranges of the electric field intensity, the leakage current hardly changes before and after the performance of annealing.
   The intensity of the electric field at which the dielectric breakdown of the silicon-containing insulating film occurs ranges between -4 MV/cm and - 5 MV/cm, and this fact implies that the copper diffusion is suppressed similarly to the first embodiment.
(3) Third embodiment
   A sample was prepared in such a manner that after a surface oxide film on a copper film was removed by a treatment prior to a film formation similarly to the first embodiment, a silicon-containing insulating film was formed on the copper film. The silicon-containing insulating film was formed under the following film forming conditions by use of a plasma enhanced CVD method.

### (Film forming condition III)

(i) condition of film forming gas
   HMDSO flow rate: 50 sccm
   N₂O flow rate: 400 sccm
   He flow rate: 400 sccm
   NH₃ gas flow rate: 200 sccm
   gas pressure: 1.0 Torr
(ii) condition for plasma formation
   high frequency power (13.56 MHz) PRF: 250 W
   low frequency power (380 KHz) PLF: 0 W
(iii) substrate heating temperature: 375 °C
(iv) formed silicon-containing insulating film
   film thickness: 100 nm
   relative dielectric constant: 3.7

   Measurements of the relative dielectric constant and the leakage current were conducted in the same manner as the first embodiment.
   According to the measurement result, the relative dielectric constant was 3.7 as described above.
   Next, the results obtained by measuring the leakage current are shown in FIG. 7 and FIG. 8. FIG. 7 and FIG. 8 are graphs obtained by examining the leakage current flowing between the mercury probe and the copper film as to the foregoing sample, which sandwich the silicon-containing insulating film therebetween. FIG. 7 illustrates the results obtained by examination immediately after forming the silicon-containing insulating film. FIG. 8 illustrates the results obtained by examination after forming the silicon-containing insulating film and after annealing the silicon-containing insulating film.
   The ordinate of FIG. 7 indicates a leakage current density (A/cm²) expressed by a logarithmic scale, and the abscissa of FIG. 7 indicates an intensity (MV/cm) of electric field expressed by a linear scale, the electric field being applied to the silicon-containing insulating film. FIG. 8 illustrates the same aspect as FIG. 7.
   As illustrated in FIG. 7 and FIG. 8, the leakage current is equal to 10⁻⁹ A/cm² when the intensity of the electric field is -1 MV/cm immediately after the film formation. After annealing, the leakage current hardly changes its value from that before annealing, except that it decreased a little around -4 MV/cm of the electric field intensity.
   The intensity of the electric field at which the dielectric breakdown of the silicon-containing insulating film occurs also ranged between -4 MV/cm and -5 MV/cm, and this fact implies that the copper diffusion is suppressed similarly to the first and second embodiments.
(4) Fourth embodiment
   A fourth embodiment of the present invention will be described with reference to FIG. 9 and FIG. 10.
   FIG. 9 is a graph illustrating states of a change of a relative dielectric constant (k) of an insulating film relative to a gas pressure (P) of a film forming gas and a relationship of a dielectric breakdown-resistance of the insulating film after annealing with the gas pressure (P) and the relative dielectric constant (k). FIG. 10 is a graph illustrating a barrier property of the insulating film for copper, for the insulating film which is prepared under a film forming condition IV.
   First, the preparation conditions of the samples S1 to S4 used for this investigation will be described. The treatment conditions prior to the film formation and the annealing conditions after the film formation are the same as those of the first embodiment. The film forming conditions are as follows.

### (Film forming condition IV)

(i) condition of film forming gas
   HMDSO flow rate: 50 sccm
   N₂O flow rate: 400 sccm
   gas pressure: parameters (0.5, 0.75, 1.0 and 1.5 Torr, each corresponding to the samples S1 to S4)
(ii) condition for plasma formation
   high frequency power (13.56 MHz) PRF: 250 W
   low frequency power (380 KHz) PLF: 0 W
(iii) substrate heating temperature: 375 °C
(iv) formed silicon-containing insulating film
   film thickness: 100 nm
   relative dielectric constant: see FIG. 9

Measurement of the relative dielectric constant was conducted before annealing in the same manner as the first embodiment. Measurement of the dielectric breakdown-resistance was conducted in the same manner as that of the measurement method of the leakage current of the first embodiment. Examination of the barrier property of the formed insulating film for copper was conducted by SIMS (Secondary Ion Mass Spectroscopy).

FIG. 9 is the graph illustrating states of the change of the relative dielectric constant (k) of the insulating film relative to the gas pressure (P) of the film forming gas and the relationship of the dielectric breakdown-resistance of the insulating film after annealing with the gas pressure (P) and the relative dielectric constant (k).

In FIG. 9, the ordinate indicates the relative dielectric constant (k) expressed by a linear scale, and the abscissa indicates the gas pressure (P) (Torr) of the film forming gas, which is expressed by a linear scale. Moreover, the measurement points are expressed by the symbol ○. In this case, the symbol ● in the symbol ○ indicates that all of the five measurement samples are not broken during the dielectric breakdown-resistance test after annealing. The symbol X in the symbol ○ indicates that all of the five measurement samples are broken. Moreover, the symbol Δ indicates that one or two measurement samples among the five measurement samples are broken. A sample in which current flows through the insulating film from the early stage of voltage application to the insulating film was judged to be broken, and a sample, in which though the dielectric breakdown voltage decreased after annealing, the insulating film showed the breakdown voltage to some degree, was judged to be sound. This is applied also for fifth to tenth embodiments to be described below.

According to the results shown in FIG. 9, as the gas pressure (P) increases, the relative dielectric constant (k) decreases. When the gas pressure (P) is equal to 1.0 Torr or less, the insulating film showed the dielectric breakdown-resistance, and did not show the dielectric breakdown-resistance when the gas pressure (P) was 1.5 Torr.

FIG. 10 is a graph illustrating investigation results of the barrier property of the formed insulating film for copper. The investigating results of FIG. 10 are obtained by investigating the copper distribution in the insulating film before and after annealing by use of SIMS.

In FIG. 10, the ordinate indicates a copper concentration (arbitrary unit) in the insulating film, which is expressed by a logarithmic scale, and the abscissa indicates measurement spots (nm) measured from the surface of the insulating film, which are expressed by a linear scale.

According to the results shown in FIG. 10, any of the samples S1 to S4 contains copper in its insulating film from the time when the samples S1 to S4 are subjected to annealing, and this is considered as that the insulating film is adulterated with the copper during the film formation. Accordingly, it is inevitable that the change of the content of the copper in the insulating film before and after annealing is observed based on FIG. 10.

When the observation is made from this viewpoint, as to the samples S3, none of the samples S3 was not broken in the dielectric breakdown-resistance test, but the samples S3 showed the copper diffusion into the insulating film. On the other hand, in the samples S1 and S2, the copper diffusion was hardly observed even after annealing. Specifically, this implies that the samples S1 and S2 possess the barrier property.
(5) Fifth embodiment
   A fifth embodiment of the present invention will be described with reference to FIG. 11.
   FIG. 11 is a graph illustrating states of a change of a relative dielectric constant (k) of an insulating film relative to a N₂O gas flow rate in a film forming gas and a relationship of a dielectric breakdown-resistance of the insulating film after annealing with the N₂O gas flow rate and the relative dielectric constant (k).
   First, preparation conditions of the samples S5 to S9 used in this investigation will be described. Treatment conditions prior to the film formation and annealing conditions are the same as those of the first embodiment. The film forming conditions are as follows.

### (Film forming condition V)

(i) condition of film forming gas
   HMDSO flow rate: 50 sccm
   N₂O flow rate: parameters (100, 200, 400, 600 and 800 sccm, each corresponding to the samples S5 to S9)
   He flow rate: 400 sccm
   gas pressure (P): 1 Torr
(ii) condition for plasma formation
   high frequency power (13.56 MHz) PRF: 250 W
   low frequency power (380 KHz) PLF: 0 W
(iii) substrate heating temperature: 375 °C
(iv) formed silicon-containing insulating film
   film thickness: 100 nm
   relative dielectric constant: see FIG. 11

   Measurement of the relative dielectric constant was conducted before annealing in the same manner as the first embodiment. Measurement of the dielectric breakdown-resistance was conducted in the same manner as that of the measurement method of the leakage current of the first embodiment.
   FIG. 11 is the graph illustrating states of the change of the relative dielectric constant (k) of the insulating film relative to the N₂O gas flow rate (sccm) in the film forming gas and the relationship of the dielectric breakdown-resistance of the insulating film after annealing with the N₂O gas flow rate and the relative dielectric constant (k). In FIG. 11, the ordinate indicates a relative dielectric constant (k) expressed by a linear scale, and the abscissa indicates a N₂O gas flow rate (sccm) in the film forming gas expressed by a linear scale.
   According to the results shown in FIG. 11, as the N₂O gas flow rate increases, the relative dielectric constant (k) decreases. When the N₂O gas flow rate becomes higher than about 400 sccm, the relative dielectric constant (k) increases as the N₂O gas flow rate becomes higher. The insulating film showed the dielectric breakdown-resistance when the N₂O gas flow rate is equal to 400 sccm or less, and did not show the dielectric breakdown-resistance when the N₂O gas flow rate was 600 sccm.
(6) Sixth embodiment

A sixth embodiment of the present invention will be described with reference to FIG. 12.

FIG 12 is a graph illustrating states of a change of a relative dielectric constant (k) of an insulating film relative to a He gas flow rate in a film forming gas, and a relationship of a dielectric breakdown-resistance of the insulating film after annealing with the He gas flow rate and the relative dielectric constant (k).

First, the preparation conditions of the samples S10 to S14 used for this investigation will be described. The treatment conditions prior to the film formation and the annealing conditions are the same as those of the first embodiment. The film forming conditions are as follows.

### (Film forming condition VI)

(i) condition of film forming gas
   HMDSO flow rate: 50 sccm
   N₂O flow rate: 400 sccm
   He flow rate: parameters (100, 200, 400, 600 and 800 sccm, each corresponding to the samples S10 to S14)
   gas pressure (P): 1 Torr
(ii) condition for plasma formation
   high frequency power (13.56 MHz) PRF: 250 W
   low frequency power (380 KHz) PLF: 0 W
(iii) substrate heating temperature: 375 °C
(iv) formed silicon-containing insulating film
   film thickness: 100 nm
   relative dielectric constant: see FIG. 12

   Measurement of the relative dielectric constant was conducted before annealing in the same manner as the first embodiment. Measurement of the dielectric breakdown-resistance was conducted in the same manner as that of the measurement method of the leakage current of the first embodiment.
   FIG 12 is the graph illustrating the states of the change of the relative dielectric constant (k) of the insulating film relative to the He gas flow rate in the film forming gas, and the relationship of the dielectric breakdown-resistance of the insulating film after annealing with the He gas flow rate and the relative dielectric constant (k).
   In FIG. 12, the ordinate indicates the relative dielectric constant (k) expressed by a linear scale, and the abscissa indicates the He gas flow rate (sccm) in the film forming gas, which is expressed by a linear scale.
   According to the results shown in FIG. 12, as the He gas flow rate became higher, the relative dielectric constant (k) gradually increased. When the He gas flow rate was equal to 400 sccm or less, the insulating film did not show the dielectric breakdown-resistance, and came to show the dielectric breakdown-resistance when the He gas flow rate exceeded 400 sccm.
(7) Seventh embodiment

A seventh embodiment of the present invention will be described with reference to FIG. 13.

FIG. 13 is a graph illustrating states of a change of a relative dielectric constant (k) of an insulating film relative to a N₂O gas flow rate in a film forming gas and a relationship of a dielectric breakdown-resistance of the insulating film after annealing with the N₂O gas flow rate and the relative dielectric constant (k). The seventh embodiment differs from the fifth embodiment (FIG.11) in that the film forming gas contains a NH₃ gas.

First, the preparation conditions of the samples S15 to S19 used for this investigation will be described. The treatment conditions prior to the film formation and the annealing conditions are the same as those of the first embodiment. The film forming conditions are as follows.

### (Film forming condition VII)

(i) condition of film forming gas
   HMDSO flow rate: 50 sccm
   N₂O flow rate: parameters (100, 200, 400, 600 and 800 sccm, each corresponding to the samples S15 to S19)
   NH₃ flow rate: 100 sccm
   He flow rate: 400 sccm
   gas pressure (P): 1 Torr
(ii) condition for plasma formation
   high frequency power (13.56 MHz) PRF: 250 W
   low frequency power (380 KHz) PLF: 0 W
(iii) substrate heating temperature: 375 °C
(iv) formed silicon-containing insulating film
   film thickness: 100 nm
   relative dielectric constant: see FIG. 13

   Measurement of the relative dielectric constant was conducted in the same manner as the first embodiment before annealing. Measurement of the dielectric breakdown-resistance was conducted in the same manner as that of the measurement method of the leakage current of the first embodiment.
   FIG. 13 is the graph illustrating the states of the change of the relative dielectric constant (k) of the insulating film relative to the N₂O gas flow rate in the film forming gas and the relationship of the dielectric breakdown-resistance of the insulating film after annealing with the N₂O gas flow rate and the relative dielectric constant (k).
   In FIG. 13, the ordinate indicates the relative dielectric constant (k) expressed by a linear scale, and the abscissa indicates the N₂O gas flow rate (sccm) in the film forming gas, which is expressed by a linear scale.
   According to the results shown in FIG. 13, as the N₂O gas flow rate becomes higher, the relative dielectric constant (k) decreases. When the N₂O gas flow rate was at a range of 400 to 600 sccm, the relative dielectric constant gradually increases. All of the samples S15 to S19 show the dielectric breakdown-resistance.
(8) Eighth embodiment

An eighth embodiment of the present invention will be described with reference to FIG. 14.

FIG. 14 is a graph illustrating states of a change of a relative dielectric constant (k) of an insulating film relative to a NH₃ gas flow rate in a film forming gas and a relationship of a dielectric breakdown-resistance of the insulating film after annealing with the NH₃ gas flow rate and the relative dielectric constant (k).

First, the preparation conditions of the samples S20 to S24 used for this investigation will be described. The treatment conditions prior to the film formation and the annealing conditions are the same as those of the first embodiment. The film forming conditions are as follows.

### (Film forming condition VIII)

(i) condition of film forming gas
   HMDSO flow rate: 50 sccm
   N₂O flow rate: 400 sccm
   NH₃ flow rate: parameters (50, 100, 200, 400 and 600 sccm, each corresponding to the samples S20 to S24)
   gas pressure (P): 1 Torr
(ii) condition for plasma formation
   high frequency power (13.56 MHz) PRF: 250 W
   low frequency power (380 KHz) PLF: 0 W
(iii) substrate heating temperature: 375 °C
(iv) formed silicon-containing insulating film
   film thickness: 100 nm
   relative dielectric constant: see FIG. 14

   Measurement of the relative dielectric constant was conducted in the same manner as the first embodiment before annealing. Measurement of the dielectric breakdown-resistance was conducted in the same manner as that of the measurement method of the leakage current of the first embodiment.
   FIG. 14 is a the graph illustrating the states of the change of the relative dielectric constant (k) of the insulating film relative to a NH₃ gas flow rate in the film forming gas and the relationship of the dielectric breakdown-resistance of the insulating film after annealing with the NH₃ gas flow rate and the relative dielectric constant (k).
   In FIG. 14, the ordinate indicates the relative dielectric constant (k) expressed by a linear scale, and the abscissa indicates the NH₃ gas flow rate (sccm) in the film forming gas, which is expressed by a linear scale.
   According to the results shown in FIG. 14, when the NH₃ gas flow rate was 50 sccm, the relative dielectric constant was about 3. Then, as the NH₃ gas flow rate increased, the relative dielectric constant (k) rapidly increased, and the relative dielectric constant (k) stabilized at an almost certain value (about 5) in case of 400 sccm or more of the NH₃ gas flow rate. All of the samples S20 to S24 showed the dielectric breakdown-resistance.
(9) Ninth embodiment

Based on the foregoing fourth to eighth embodiments, it was proved that the dielectric breakdown-resistance is larger as the relative dielectric constant is higher. Therefore, it is difficult for the single layers composed of the insulating films according to the fourth to eighth embodiments to meet the demand for a low relative dielectric constant and a high dielectric breakdown-resistance. In order to meet this demand, it is suitable that the insulating film is at least composed of two or more layers, in which an insulating film showing an excellent dielectric breakdown-resistance in spite of a high relative dielectric constant and an insulating film showing a low relative dielectric breakdown-resistance in spite of a low relative dielectric constant are stacked. In this case, particularly in order to satisfactory meet a demand for the low relative dielectric constant and the high dielectric breakdown-resistance, it is preferable that an insulating film showing an excellent dielectric breakdown-resistance is made to be thin and an insulating film showing a low relative dielectric constant is made to be thick.

The experiment results of the ninth embodiment of the present invention conducted in complying with this spirit will be described with reference to FIGs. 15 to 18.

The ninth embodiment differs from the fourth to eighth embodiments in that an insulating film composed of a underlying film (symbol □) covering copper and a main insulating film (symbol ○) formed on the underlying film is formed. The thickness of the underlying film was set to 10 nm, and the thickness of the main insulating film was set to 90 nm. In this embodiment, the dielectric breakdown-resistance of the entire two-layered structure formed of the two insulating films was investigated.

In FIG. 15, the sorts (L1 to L3) of the underlying films prepared by changing the gas pressure P are shown, and the relationship between the gas pressure P and the relative dielectric constant is shown.

In FIG. 16, the sorts (L4 and L5) of the underlying films prepared by changing the N₂O gas flow rate are shown, and the relationship between the N₂O gas flow rate and the relative dielectric constant is shown.

In FIG. 17, the sorts (U1 to U3) of the main insulating films prepared by changing the gas pressure P are shown, and the relationship between the gas pressure P and the relative dielectric constant is shown.

In FIG. 18, the results obtained by investigating the dielectric breakdown-resistance of the two-layered insulating film (S25 to S31) in which the underlying film of FIGs. 15 and 16 and the main insulating film of FIG. 17 are combined.

FIG. 15 is a graph illustrating states of a change of the relative dielectric constant (k) of a underlying film relative to the gas pressure (P) of a film forming gas. In FIG. 15, the ordinate indicates the relative dielectric constant (k) expressed by a linear scale, and the abscissa indicates the gas pressure (P) (Torr) of the film forming gas, which is expressed by a linear scale.

First, the preparation conditions of the samples L1 to L3 used for this investigation will be described. The treatment conditions prior to the film formation and the annealing conditions are the same as those of the first embodiment. The film forming conditions are as follows.

### (Film forming condition IX)

(i) condition of film forming gas
   HMDSO flow rate: 50 sccm
   N₂O flow rate: 400 sccm
   He gas flow rate: 400 sccm
   gas pressure (P): 0.5, 1.0 and 1.5 Torr (0.5 Torr for L1, 1.0 Torr for L2, and 1.5 Torr for L3)
(ii) condition for plasma formation
   high frequency power (13.56 MHz) PRF: 250 W
   low frequency power (380 KHz) PLF: 0 W
(iii) substrate heating temperature: 375 °C
(iv) formed silicon-containing insulating film (underlying film)
   film thickness: 10 nm
   relative dielectric constant: see FIG. 15

   Measurements of the relative dielectric constant were conducted before annealing in the same manner as that of the first embodiment.
   According to the results shown in FIG. 15, as the gas pressure (P) increases, the relative dielectric constant (k) also increases. When the gas pressure (P) is equal to 0.5 Torr, the relative dielectric constant is about 3.5, and when the gas pressure (P) is 1.0 Torr, the relative dielectric constant is about 2.9, When the gas pressure P is 1.5 Torr, the relative dielectric constant is about 2.7.
   FIG. 16 is a graph illustrating states of a change of the relative dielectric constant (k) of the formed underlying film relative to the N₂O gas flow rate in the film forming gas. In FIG. 16, the ordinate indicates the relative dielectric constant (k) expressed by a linear scale, and the abscissa indicates the N₂O gas flow rate (sccm) in the film forming gas, which is expressed by a linear scale.
   First, the preparation conditions of the samples L4 and L5 used for this investigation will be described. The treatment conditions prior to the film formation and the annealing conditions are the same as those of the first embodiment. The film forming conditions are as follows.

### (Film forming condition X)

(i) condition of film forming gas
   HMDSO flow rate: 50 sccm
   N₂O flow rate: 100 and 400 sccm (100 sccm for L4, and 400 sccm for L5)
   He gas flow rate: 400 sccm
   gas pressure (P): 1.0 Torr
(ii) condition for plasma formation
   high frequency power (13.56 MHz) PRF: 250 W
   low frequency power (380 KHz) PLF: 0 W
(iii) substrate heating temperature: 375 °C
(iv) formed silicon-containing insulating film (underlying film)
   film thickness: 10 nm
   relative dielectric constant: see FIG. 16

   Measurement of the relative dielectric constant was conducted in the same manner as the first embodiment before annealing.
   According to the results shown in FIG. 16, when the N₂O gas flow rate was 100 sccm, the relative dielectric constant was about 3.1, and when the N₂O gas flow rate was 400 sccm, the relative dielectric constant was about 2.9.
   FIG. 17 is a graph illustrating states of a change of a relative dielectric constant (k) of a main insulating film relative to a gas pressure P of the film forming gas, which is prepared under a film forming condition XI. In FIG. 17, the ordinate indicates the relative dielectric constant (k) expressed by a linear scale, and the abscissa indicates the gas pressure (Torr) of the film forming gas, which is expressed by a linear scale.
   First, the preparation conditions of the samples U1 to U3 used for this investigation will be described. The treatment conditions prior to the film formation and the annealing conditions are the same as those of the first embodiment. The film forming conditions are as follows.

### (Film forming condition XI)

(i) condition of film forming gas
   HMDSO flow rate: 50 sccm
   N₂O flow rate: 400 sccm
   He flow rate: 400 sccm
   gas pressure (P): 0.5, 1.0 and 1.5 Torr (0.5 Torr for U1, 1.0 Torr for U2, and 1.5 Torr is for U3)
(ii) condition for plasma formation
   high frequency power (13.56 MHz) PRF: 250 W
   low frequency power (380 KHz) PLF: 0 W
(iii) substrate heating temperature: 375 °C
(iv) formed silicon-containing insulating film (main insulating film)
   film thickness: 90 nm
   relative dielectric constant: see FIG. 17

   Measurements of the relative dielectric constant were conducted before annealing in the same manner as that of the first embodiment.
   According to the results shown in FIG. 17, as to the main insulating film, when the gas pressure was 0.7 Torr, the relative dielectric constant was about 3.1, and when the gas pressure was 1.0 Torr, the relative dielectric constant was about 2.9. When the gas pressure was 1.5 Torr, the relative dielectric constant was about 2.7.
   Next, concerning the two-layered insulating film (S25 to S31) in which the main insulating film (U1 to U3) and the various underlying films (L1 to L5) are combined, the dielectric breakdown-resistance acquired will be described. The insulating film S25 is obtained by combining the underlying film L1 and the main insulating film U1. The insulating film S26 is obtained by combining the underlying film L1 and the main insulating film U2. The insulating film S27 is obtained by combining the underlying film L1 and the main insulating film U3. The insulating film S28 is obtained by combining the underlying film L2 and the main insulating film U3. The insulating film S29 is obtained by combining the underlying film L3 and the main insulating film U2. The insulating film S30 is obtained by combining the underlying film L4 and the main insulating film U3. The insulating film S31 is obtained by combining the underlying film L5 and the main insulating film U3.
   FIG. 18 is a graph illustrating a dielectric breakdown-resistance acquired for the samples S25 to S31. The abscissa indicates the relative dielectric constant of the underlying film, which is expressed by a linear scale, and the ordinate indicates the relative dielectric constant of the main insulating film, which is expressed by a linear scale. Measurements of the dielectric breakdown-resistance were conducted according to the same method as the measurement method of the leakage current of the first embodiment.
   According to FIG. 18, only the sample S29 has insufficient dielectric breakdown-resistance, and the samples other than the sample S29 have sufficient dielectric breakdown-resistance. Herein, with respect to the relative dielectric constant of the underlying films, only the sample S29 has a relative dielectric constant as low as 2.7, and the samples other than the sample S29 have relative dielectric constants of 2.9 or more. Moreover, with respect to the relative dielectric constant of the main insulating films, the samples S27, S28, S30 and S31 have a relative dielectric constant as low as 2.7, and other samples have relative dielectric constants of 2.9 or more. In other words, when the relative dielectric constant of the underlying film is low, the dielectric breakdown-resistance tends to decrease irrespective of the magnitude of the relative dielectric constant of the main insulating film. Specifically, this implies that the dielectric breakdown-resistance is decided depending on the nature of the underlying film. In order to increase the dielectric breakdown-resistance of the two-layered insulating film, the relative dielectric constant of the underlying film must be made to be high to some degree.
   Based on these results, in order to meet the demand for the low relative dielectric constant and the high dielectric breakdown-resistance, the insulating film is preferably formed so that the underlying film is formed to be as thin as possible by increasing the relative dielectric constant of the underlying film to some degree, and so that the insulating film has a thickness necessary to serve as an interlayer insulating film by decreasing the relative dielectric constant of the main insulating film as low as possible.
   Although the invention has been described in detail with reference to embodiments, the scope and spirit of the present invention are not limited to the specific examples described in the above-described embodiments. It should be understood that various changes, substitutions and alternations can be made hereto without the parting from the spirit and scope of the invention.
   For example, in the first embodiment, though hexamethyldisiloxane (HMDSO) is used as the alkyl compound having the siloxane bond, alkyl compounds having the siloxane bond other than the foregoing alkyl compound, for example, octamethylcyclotetrasiloxane (OMCTS), tetramethylcyclotetrasiloxane (TMCTS) or octamethyl-trisiloxane (OMTS), can be used.
   Moreover, in the first embodiment, though the dinitrogen monoxide (N₂O) gas is used as the oxygen-containing gas, any one of oxygen (O₂), water (H₂O) and carbon dioxide (CO₂) may be used instead of dinitrogen monoxide (N₂O).
   In the first to third embodiments, though the gas containing hydrocarbon is not used, methane (CH₄) or acetylene (C₂H₂) may be added thereto.
   Furthermore, without using the alkyl compound having the siloxane bond of the foregoing embodiment, methyl silane or an alkyl compound having an O-Si-O bond can alternatively be used.
   In this case, any one of monomethyl silane (SiH₃(CH₃)), dimethyl silane (SiH₂(CH₃)₂), trimethyl silane (SiH(CH₃)₃) and tetramethyl silane (Si(CH₃)₄) can be used as methyl silane. As the alkyl compound having an O-Si-O bond, a compound having a structural formula of CH₃-O-Si(CH₃)₂-O-CH₃ can be used.
   As described above, according to the present invention, a film forming gas containing an alkyl compound and an oxygen-containing gas is supplied between the first and second electrodes, and the gas pressure is regulated to 1 Torr or less. Thereafter, the high frequency power of a frequency of 1 MHz or more is supplied to any one of the first and second electrodes, and thus the film forming gas is converted into a plasma state. The alkyl compound and the oxygen-containing gas contained in the plasmanized film forming gas are reacted with each other, and the barrier insulating film covering the copper wiring is formed.
   By use of the film forming gas converted into a plasma state only by the high frequency power, it is possible to achieve the low relative dielectric constant. Moreover, by regulating the pressure of the film forming gas to 1 Torr or less at least at the early stage of the film formation, it is possible to maintain the denseness of the insulating film enough to prevent the copper diffusion.
   Moreover, by any one of the following methods or combinations of them, denseness of the insulating film can be enhanced while maintaining the low relative dielectric constant: the insulating film is formed while increasing the pressure of the film forming gas from a low pressure to a pressure of 1 Torr gradually; the film forming gas containing at least any one of ammonium (NH₃) and nitrogen (N₂) is used for the formation of the insulating film; at least any one of ammonium (NH₃) and nitrogen (N₂) is added to the film forming gas at the early stage of the film formation; the film forming gas containing the dilution gas of at least any one of He and Ar is used; the film forming gas containing the dilution gas is used while increasing the flow rate of the dilution gas; and the bias power of the low frequency is applied at the early stage of the film formation.
   Moreover, by adding the hydrocarbon, the formed film can be enhanced in the etching selectivity for the etchant of the insulating film with the low relative dielectric constant.

## Claims

1. A method of manufacturing a semiconductor device, comprising the steps of:
connecting a supply power source (7) for supplying high frequency power of a frequency of 1 MHz or more to a first electrode (2), and holding a substrate (21) on a second electrode (3) facing the first electrode (2), the substrate (21) on which at least any one of a wiring and an electrode mainly made of a copper film is formed;
supplying a film forming gas containing an alkyl compound and an oxygen-containing gas between the first and second electrodes (2), (3), and regulating a gas pressure of the film forming gas to 1 Torr or less; and
supplying the high frequency power to any one of the first and second electrodes (2), (3) to convert the film forming gas into a plasma, and allowing the alkyl compound and the oxygen-containing gas of the film forming gas to react with each other and thus form a barrier insulating film covering any one of the wiring and the electrode.

2. The method according to claim 1,
wherein the alkyl compound is any one of hexamethyldisiloxane (HMDSO :(CH₃)₃Si-O-Si(CH₃)₃), octamethylcyclotetrasiloxane (OMCTS), tetramethylcyclotetrasiloxane (TMCTS) and octamethyltrisiloxane (OMTS).

3. The method according to claim 1,
wherein the alkyl compound is any one of monomethylsilane (SiH₃(CH₃)), dimethylsilane (SiH₂(CH₃)₂), trimethylsilane (SiH(CH₃)₃) and tetramethylsilane (Si(CH₃)₄).

4. The method according to claim 1,
wherein the alkyl compound is a compound having an O-Si-O bond.

5. The method according to claim 4,
wherein the compound having the O-Si-O bond is CH₃-O-Si(CH₃)₂-O-CH₃.

6. The method according to claim 1,
wherein the oxygen-containing gas is any one of O₂, N₂O, H₂O and CO₂.

7. The method according to claim 6,
wherein the oxygen-containing gas is N₂O, and a flow rate of the oxygen-containing gas relative to the alkyl compound is equal to 8 or less.

8. The method according to claim 1,
wherein the film forming gas contains a dilution gas composed of at least any one of He and Ar.

9. The method according to claim 8,
wherein the dilution gas is He, and a flow rate of the dilution gas relative to the alkyl compound is equal to 8 or more.

10. The method according to any one of claims 1, 8 and 9,
wherein the film forming gas contains hydrocarbon.

11. The method according to claim 10,
wherein the hydrocarbon is any one of methane (CH₄), acetylene (C₂H₂) and ethylene (C₂H₄).

12. The method according to claim 1,
wherein any one of an ammonium gas and a nitrogen gas is added to the film forming gas at least at an early stage of the step of converting the film forming gas into the plasma and allowing the alkyl compound and the oxygen-containing gas of the film forming gas to react with each other and thus form the barrier insulating film covering any one of the wiring and the electrode.

13. The method according to any one of claims 8 and 9,
wherein the flow rate of the dilution gas is increased at least at an early stage of the step of converting the film forming gas into the plasma and allowing the alkyl compound and the oxygen-containing gas of the film forming gas to react with each other and thus form the barrier insulating film covering any one of the wiring and the electrode.

14. The method according to claim 1,
wherein in the step of forming the barrier insulating film, the barrier insulating film is formed while increasing a pressure of the film forming gas from a low pressure to 1 Torr gradually.

15. The method according to claim 1,
wherein in the step of converting the film forming gas into the plasma and allowing the alkyl compound and the oxygen-containing gas of the film forming gas to react with each other and thus form the barrier insulating film covering any one of the wiring and the electrode, the insulating film is formed in a manner that a gas pressure is kept at 1 Torr or less in an early stage of a film formation, and kept at a pressure higher than 1 Torr in a remaining stage thereof to completion of the film formation of the barrier insulating film.

16. The method according to claim 1,
wherein only at an early stage of the step of supplying the high frequency power to any one of the first and second electrodes (2), (3) to convert the film forming gas into the plasma, and allowing the alkyl compound and the oxygen-containing gas of the film forming gas to react with each other and thus form the barrier insulating film covering any one of the wiring and the electrode, the high frequency power is supplied to any one of the first and second electrodes (2), (3), and low frequency power of a frequency equal to or larger than 50 kHz and less than 1 MHz is supplied to the electrode (3), (2) other than that supplied with the high frequency power.

17. The method according to claim 1,
wherein after the step of forming the barrier insulating film covering any one of the wiring and the electrode, plasma composed of any one of an inert gas, a nitrogen gas, an ammonium gas and a dinitrogen monoxide gas is contacted onto a surface of the barrier insulating film.
